# EUROPEAN PATENT APPLICATION

(11) **EP 4 482 030 A1**
(43) Date of publication of application: **25.12.2024**
(21) Application number: 22927318.0
(22) Date of filing: 07.12.2022
(51) Int. Cl.: H03H 7/38, H05B 6/68

(54) **HIGH-FREQUENCY PROCESSING DEVICE**

(30) Priority: 16.02.2022 JP 2022021735
(71) Applicant: Panasonic Intellectual Property Management Co., Ltd., Kadoma-shi, Osaka 571-0057 (JP)
(72) Inventor: OKAJIMA Toshiyuki, Osaka 571-0057 (JP); UNO Takashi, Osaka 571-0057 (JP); FUKUI Mikio, Osaka 571-0057 (JP)
(74) Representative: SSM Sandmair
(86) International application number: PCT/JP2022/045029
(87) International publication number: WO 2023/157431

(57) **Abstract**

A high-frequency processing device includes a high-frequency power supply, a high-frequency power radiation unit, an impedance adjustment unit, a power detection unit, and a control unit. The high-frequency power supply generates high-frequency power of variable magnitude. The high-frequency power radiation unit emits the high-frequency power toward a target object. The impedance adjustment unit adjusts a load impedance. The power detection unit detects supplied power and reflected power. The control unit calculates a reflectance and a phase difference to obtain the load impedance. The control unit determines whether or not the load impedance falls within a predetermined impedance region corresponding to output power of the high-frequency power supply. The control unit causes the impedance adjustment unit to guide the load impedance to and maintain the load impedance within the predetermined impedance region corresponding to the output power of the high-frequency power supply.

## Description

### TECHNICAL FIELD

The present disclosure relates to a high-frequency processing device for processing a target object with high-frequency power.

### BACKGROUND ART

In high-frequency processing devices, various techniques have been disclosed for protecting a high-frequency amplifying device of a high-frequency power supply that outputs high-frequency power with high power.

For example, PTL 1 discloses a high-frequency power supply device equipped with a circulator disposed on an output side of a power amplifier. In this high-frequency power supply device, the circulator guides reflected power to an absorption resistor and the absorption resistor absorbs the reflected power, so that the reflected power does not return to the power amplifier. As a result, a damage to the power amplifier by the reflected power is prevented.

PTL 2 discloses a high-frequency power supply device equipped with an amplifying element having ferrite on input and output sides. In this high-frequency power supply device, a ferrite temperature is measured to reduce or stop an output from the high-frequency power supply device when the temperature exceeds a threshold. As a result, a damage to the amplifying element in the high-frequency power supply device is prevented.

PTL 3 discloses a high-frequency power transmission circuit including a variable attenuation circuit connected to an output terminal of a power amplifying circuit and a reflected power detection circuit for detecting the reflected power. In this high-frequency power transmission circuit, attenuation of the variable attenuation circuit is controlled according to magnitude of the reflected power, so that the reflected power greater than or equal to a specified value does not return to the power amplifying circuit. As a result, a damage to an amplifying element of the power amplifying circuit is prevented.

### Citation List

### Patent Literature

PTL 1: Unexamined Japanese Patent Publication No. H5-048353
PTL 2: Unexamined Japanese Patent Publication No. 2010-114982
PTL 3: Unexamined Japanese Patent Publication No. 2006-166153

### SUMMARY OF THE INVENTION

In PTL 1, a circulator is the most technically effective means to prevent a damage to a power amplifier. However, a physical shape of the circulator depends on a radio wavelength. Thus, although the use of circulator is practical at frequencies of a microwave band of several gigahertz, the use of circulator is not practical at frequencies of a high-frequency band of several hundreds of megahertz or less. In addition, the circulator is extremely expensive and results in a cost increase.

In both PTL 2 and PTL 3, an output of high-frequency power is reduced or stopped to prevent a damage to an amplifying element. This may decrease processing capability.

An object of the present disclosure is to provide a high-frequency processing device having a high processing capability and operable to prevent a damage to a high-frequency amplifying device of a high-frequency power supply without decreasing high-frequency power output.

The high-frequency processing device according to one aspect of the present disclosure includes, for performing a high-frequency process on a target object, a high-frequency power supply, a high-frequency power radiation unit, an impedance adjustment unit, a power detection unit, and a control unit.

The high-frequency power supply generates high-frequency power of variable magnitude. The high-frequency power radiation unit emits the high-frequency power toward the target object. The impedance adjustment unit adjusts a load impedance relative to the high-frequency power supply. The power detection unit detects supplied power from the high-frequency power supply and reflected power that flows reversely to the high-frequency power supply. The control unit controls the high-frequency power supply and the impedance adjustment unit.

The control unit calculates a reflectance that is a ratio of the reflected power to the supplied power, and a phase difference between the supplied power and the reflected power. The control unit further causes the impedance adjustment unit to adjust the load impedance, whereby the reflectance and the phase difference are adjusted to a predetermined reflectance and a predetermined phase difference, respectively.

The high-frequency processing device of the present disclosure is operable to prevent a damage to the high-frequency amplifying device of the high-frequency power supply and adjusting the load impedance so as to maintain a high processing capability without decreasing the output power of the high-frequency power supply regardless of the type and condition of the target object.

### BRIEF DESCRIPTION OF DRAWINGS

FIG. 1 is a block diagram illustrating a basic configuration of a high-frequency processing device according to a first exemplary embodiment of the present disclosure.
FIG. 2 is a block diagram illustrating a configuration of a high-frequency power supply of the high-frequency processing device according to the first exemplary embodiment.
FIG. 3 is a block diagram illustrating a configuration of a power detection unit of the high-frequency processing device according to the first exemplary embodiment.
FIG. 4 is a diagram illustrating a circuit configuration of an impedance adjustment unit of the high-frequency processing device according to the first exemplary embodiment.
FIG. 5 is a flow chart illustrating a basic control procedure of the high-frequency processing device according to the first exemplary embodiment.
FIG. 6 is an example of output load characteristics of a high-output high-frequency transistor.
FIG. 7 is a diagram illustrating an impedance region of a load normalized by an output impedance.
FIG. 8A is a diagram illustrating an impedance control with respect to an output of the high-frequency power supply by the impedance adjustment unit of the high-frequency processing device according to the first exemplary embodiment.
FIG. 8B is a diagram illustrating the impedance control with respect to the output of the high-frequency power supply by the impedance adjustment unit of the high-frequency processing device according to the first exemplary embodiment.
FIG. 8C is a diagram illustrating the impedance control with respect to the output of the high-frequency power supply by the impedance adjustment unit of the high-frequency processing device according to the first exemplary embodiment.
FIG. 9 is a diagram illustrating a region to be avoided in a predetermined impedance region corresponding to output power of the high-frequency processing device according to the first exemplary embodiment.
FIG. 10 is a block diagram illustrating a basic configuration of a high-frequency processing device according to a second exemplary embodiment of the present disclosure.
FIG. 11 is a block diagram illustrating a configuration of a high-frequency power supply of the high-frequency processing device according to the second exemplary embodiment.
FIG. 12 is a diagram illustrating a predetermined impedance region of an output of the high-frequency power supply of the high-frequency processing device according to the second exemplary embodiment.
FIG. 13A is a diagram illustrating an impedance control with respect to the output of the high-frequency power supply by an impedance adjustment unit of the high-frequency processing device according to the second exemplary embodiment.
FIG. 13B is a diagram illustrating the impedance control with respect to the output of the high-frequency power supply by the impedance adjustment unit of the high-frequency processing device according to the second exemplary embodiment.
FIG. 13C is a diagram illustrating the impedance control with respect to the output of the high-frequency power supply by the impedance adjustment unit of the high-frequency processing device according to the second exemplary embodiment.

### DESCRIPTION OF EMBODIMENT

A high-frequency processing device according to a first aspect of the present disclosure includes, for performing a high-frequency process on a target object, a high-frequency power supply, a high-frequency power radiation unit, an impedance adjustment unit, a power detection unit, and a control unit.

The high-frequency power supply generates high-frequency power of variable magnitude. The high-frequency power radiation unit emits the high-frequency power toward the target object. The impedance adjustment unit adjusts a load impedance relative to the high-frequency power supply. The power detection unit detects supplied power from the high-frequency power supply and reflected power that flows reversely to the high-frequency power supply. The control unit controls the high-frequency power supply and the impedance adjustment unit.

The control unit calculates a reflectance that is a ratio of the reflected power to the supplied power, and a phase difference between the supplied power and the reflected power. The control unit further causes the impedance adjustment unit to adjust the load impedance, whereby the reflectance and the phase difference are adjusted to a predetermined reflectance and a predetermined phase difference, respectively.

According to the first aspect, a damage to a high-frequency amplifying device of the high-frequency power supply is prevented and also a high processing capability can be maintained without decreasing high-frequency power output.

When the high-frequency power supply does not include a circulator, the reflected power flows reversely to the high-frequency amplifying device. In this case, in the high-frequency amplifying device, a voltage waveform and a current waveform caused by the reflected power are superimposed on a normal voltage waveform and a normal current waveform, respectively, inside the high-frequency amplifying device. This changes the voltage waveform and the current waveform inside the high-frequency amplifying device.

As a result, overlapped voltage waveforms may cause a larger amplitude, or distorted voltage waveform and current waveform may increase high-frequency power consumed inside the high-frequency amplifying device without being externally output.

Ideally, it is preferrable to continuously adjust the load impedance to maintain a condition of no generation of the reflected power. However, the reflected power is generated to some extent due to the type of load, fluctuation of the load impedance during the high-frequency process, accuracy of a detection circuit, and the like. Thus, it is important to appropriately control the reflectance and the phase difference.

In a high-frequency processing device according to a second aspect of the present disclosure, in addition to the first aspect, the control unit determines whether or not the reflectance and the phase difference fall within a predetermined region corresponding to output power of the high-frequency power supply. The control unit further causes the impedance adjustment unit to adjust the load impedance, whereby the reflectance and the phase difference are guided to and maintained within the predetermined region.

According to the second aspect, a damage to the high-frequency amplifying device of the high-frequency power supply is prevented and also a high processing capability is maintained regardless of an increase or decrease in the output power of the high-frequency power supply.

In a high-frequency processing device according to a third aspect of the present disclosure, in addition to the first or second aspect, the control unit obtains the load impedance from the reflectance and the phase difference. The control unit determines whether or not the load impedance falls within a predetermined impedance region corresponding to the output power of the high-frequency power supply in a Smith chart indicating complex impedances. Accordingly, the control unit determines whether or not the reflectance and the phase difference fall within the predetermined region.

The control unit further causes the impedance adjustment unit to guide the load impedance to and maintain the load impedance within the predetermined impedance region, whereby the reflectance and the phase difference are guided to and maintained within the predetermined region.

According to the third aspect, a damage to the high-frequency amplifying device of the high-frequency power supply is prevented and also a high processing capability is maintained regardless of an increase or decrease in the output power of the high-frequency power supply.

In general, the output impedance and a passing characteristic of the high-frequency amplifying device fluctuate depending on the output power. In particular, when the high-frequency power supply is not equipped with the circulator, fluctuation of the output impedance of the high-frequency amplifying device is associated with fluctuation of the output impedance of the high-frequency power supply. Therefore, it is preferable to adjust the load impedance to that suitable for the output power.

In a fourth aspect of the present disclosure, in addition to any one of the first to third aspects, the power detection unit detects the supplied power and the reflected power at predetermined time intervals or continuously. The control unit calculates the reflectance and the phase difference.

According to the fourth aspect, the load impedance relative to the high-frequency power supply can be maintained at a predetermined value even when a condition of the target object changes during the high-frequency process. As a result, a damage to the high-frequency amplifying device of the high-frequency power supply is prevented and high-processing capability is maintained without decreasing the high-frequency power output.

In a high-frequency processing device according to a fifth aspect of the present disclosure, in addition to any one of the first to fourth aspects, the control unit causes the impedance adjustment unit to adjust the load impedance to avoid the reflectance from becoming less than or equal to a predetermined threshold.

According to the fifth aspect, the load impedance relative to the high-frequency power supply can be moved to within a range corresponding to the output power of the high-frequency power supply. As a result, a damage to the high-frequency amplifying device of the high-frequency power supply is prevented and also a high processing capability can be maintained regardless of the type and condition of the target object and any change in the condition.

Exemplary embodiments of the present disclosure will be described below with reference to the drawings.

### (First exemplary embodiment)

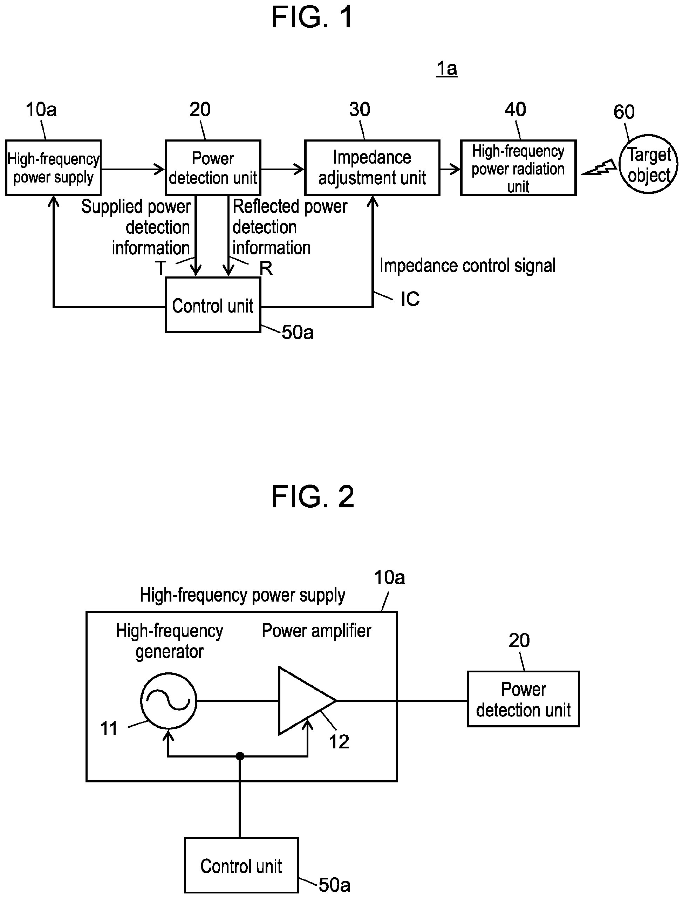

FIG. 1 is a block diagram illustrating a basic configuration of high-frequency processing device 1a according to a first exemplary embodiment of the present disclosure. As illustrated in FIG. 1, high-frequency processing device 1a includes high-frequency power supply 10a, power detection unit 20, impedance adjustment unit 30, high-frequency power radiation unit 40, and control unit 50a, and performs processing on target object 60 by high-frequency power.

To simplify the description, high-frequency processing device 1a includes one each of the high-frequency power supply, the high-frequency power detection unit, the impedance adjustment unit, and the high-frequency power radiation unit. However, their number of pieces is not limited thereto.

High-frequency power supply 10a generates a high-frequency signal, and the high-frequency signal is output after high-frequency power of the high-frequency signal is amplified to magnitude suitable for performing a high-frequency process on target object 60. Power detection unit 20 detects supplied power and reflected power, and outputs supplied power information T and reflected power information R to control unit 50a. A configuration of high-frequency power supply 10a and a configuration of power detection unit 20 will be described later.

The supplied power refers to high-frequency power generated by high-frequency power supply 10a and supplied from high-frequency power radiation unit 40 to target object 60 via power detection unit 20. The reflected power is high-frequency power, in the supplied power, reflected on target object 60 and flowing reversely to high-frequency power supply 10a via high-frequency power radiation unit 40. Supplied power information T includes magnitude and phase of the supplied power. Reflected power information R includes magnitude and phase of the reflected power.

Control unit 50a outputs impedance control signal IC to control impedance adjustment unit 30 with this signal. Impedance adjustment unit 30 adjusts, according to impedance control signal IC, an impedance of a load seen from an output terminal of high-frequency power supply 10a.

Hereinafter, the impedance of the load seen from the output terminal of the high-frequency power supply is referred to as a load impedance relative to the high-frequency power supply or simply a load impedance. A value of the load impedance relative to the high-frequency power supply is referred to as a load impedance value.

Impedance adjustment unit 30 is configured with a circuit including both or one of a variable inductance element and a variable capacitance element. Impedance adjustment unit 30 changes, according to impedance control signal IC, both or one of values of the variable inductance element and the variable capacitance element. As a result, the load impedance is adjusted to a target impedance. The configuration of impedance adjustment unit 30 will be described later.

High-frequency power radiation unit 40 emits the high-frequency power from impedance adjustment unit 30 to target object 60. High-frequency power radiation unit 40 may be configured to emit the high-frequency power toward target object 60. For example, high-frequency power radiation unit 40 may be a radiation antenna such as a horn antenna, pole antenna, and patch antenna. High-frequency power radiation unit 40 may be configured to form a high-frequency electric field between two parallel electrodes to process target object 60 disposed between the parallel electrodes.

Control unit 50a calculates a reflectance and a phase difference based on supplied power information T and reflected power information R. The reflectance is a ratio of the reflected power to the supplied power. The phase difference is a phase difference between the supplied power and the reflected power, and is a relative phase of the reflected power to the supplied power.

Control unit 50a obtains the load impedance from the reflectance and the phase difference calculated. Control unit 50a causes impedance adjustment unit 30 to adjust the load impedance based on the reflectance and the phase difference calculated.

FIG. 2 is a block diagram illustrating a configuration of high-frequency power supply 10a. FIG. 2 also illustrates other components (power detection unit 20 and control unit 50a) connected to high-frequency power supply 10a. As illustrated in FIG. 2, high-frequency power supply 10a includes high-frequency generator 11 and power amplifier 12.

High-frequency generator 11 is an oscillator that generates a high-frequency signal at an arbitrary frequency in a predetermined frequency band. High-frequency generator 11 may be configured with, for example, a crystal oscillator (XO) at a fixed frequency employing a crystal resonator or a voltage-controlled oscillator (VCO) whose oscillation frequency changes by frequency control voltage. High-frequency generator 11 may be configured with a phase locked loop (PLL) that locks the phase of the oscillator by a phase comparator.

Power amplifier 12 amplifies the high-frequency signal generated by high-frequency generator 11, and outputs the high-frequency power of magnitude suitable for performing the high-frequency process on target object 60. Control unit 50a controls high-frequency generator 11 and power amplifier 12.

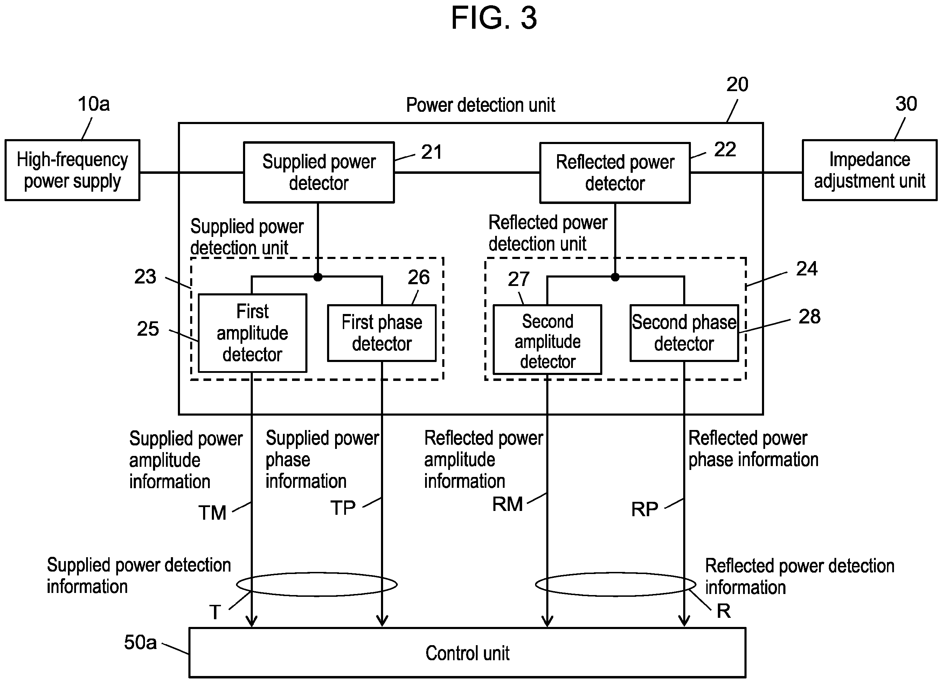

FIG. 3 is a block diagram illustrating a configuration of power detection unit 20. FIG. 3 also illustrates other components (high-frequency power supply 10a, impedance adjustment unit 30, and control unit 50a) connected to power detection unit 20. As illustrated in FIG. 3, power detection unit 20 includes supplied power detector 21, reflected power detector 22, supplied power detection unit 23, and reflected power detection unit 24.

Supplied power detector 21 branches part of the high-frequency power (supplied power) generated by high-frequency power supply 10a and supplied to impedance adjustment unit 30. Supplied power detector 21 outputs this branched part of the supplied power to supplied power detection unit 23 as detected supplied power.

Reflected power detector 22 branches part of the high-frequency power (reflected power) flowing reversely to high-frequency power supply 10a from impedance adjustment unit 30. Reflected power detector 22 outputs this branched part of the reflected power to reflected power detection unit 24 as detected reflected power. Supplied power detector 21 and reflected power detector 22 may be a directional coupler, a circulator, a hybrid coupler, or the like.

In FIG. 3, supplied power detector 21 and reflected power detector 22 are illustrated separately. However, for example, supplied power detector 21 and reflected power detector 22 are configured with a directional coupler or a hybrid coupler to output the detected supplied power and the detected reflected power.

Supplied power detection unit 23 includes first amplitude detector 25 and first phase detector 26. The detected supplied power branched by supplied power detector 21 is input to first amplitude detector 25 and first phase detector 26. Reflected power detection unit 24 includes second amplitude detector 27 and second phase detector 28. The detected reflected power branched by reflected power detector 22 is input to second amplitude detector 27 and second phase detector 28.

First amplitude detector 25 outputs a voltage value corresponding to the magnitude of the detected supplied power to control unit 50a as supplied power amplitude information TM. Second amplitude detector 27 outputs a voltage value corresponding to the magnitude of the detected reflected power to control unit 50a as reflected power amplitude information RM.

First amplitude detector 25 and second amplitude detector 27 have well-known configurations. For example, first amplitude detector 25 and second amplitude detector 27 are configured by combining a rectifying circuit including a Schottky barrier diode and an integrating circuit including a resistor and a capacitor.

First phase detector 26 outputs a voltage value corresponding to a phase of the detected supplied power to control unit 50a as supplied power phase information TP. Second phase detector 28 outputs a voltage value corresponding to a phase of the detected reflected power to control unit 50a as reflected power phase information RP.

First phase detector 26 and second phase detector 28 have well-known configurations. For example, first phase detector 26 and second phase detector 28 are configured with a quadrature detector. The quadrature detector shifts the phase of the high-frequency signal input by 90 degrees and demodulates the high-frequency signal input. Then, the quadrature detector outputs a voltage of in-phase component (I) and a voltage of quadrature component (Q) in a waveform of the high-frequency signal as a detected voltage.

Control unit 50a can calculate the phase of the high-frequency signal by using in-phase component (I) and quadrature component (Q) obtained from the quadrature detector. More specifically, the phase of the high-frequency signal is calculated by obtaining an arc tangent (tan⁻¹) of a value dividing the voltage of in-phase component (I) by the voltage of quadrature component (Q).

Control unit 50a calculates a phase value of the supplied power from the voltage of in-phase component (I) and the voltage of quadrature component (Q) obtained from first phase detector 26. Control unit 50a calculates a phase value of the reflected power from the voltage of in-phase component (I) and the voltage of quadrature component (Q) obtained from second phase detector 28. Control unit 50a calculates a relative phase of the reflected power to the supplied power, i.e., a phase difference between the supplied power and the reflected power, by obtaining a difference between these two phase values.

An amplitude can also be calculated from a root-mean-square value of the voltage of in-phase component (I) and the voltage of quadrature component (Q) by using the voltage of in-phase component (I) and the voltage of quadrature component (Q) obtained from the quadrature detector. Therefore, first amplitude detector 25 and first phase detector 26 may be configured with one quadrature detector, and second amplitude detector 27 and second phase detector 28 may be configured with one quadrature detector.

In FIG. 3, first amplitude detector 25 and first phase detector 26 are illustrated separately. First amplitude detector 25 outputs supplied power amplitude information TM and first phase detector 26 outputs supplied power phase information TP. However, first amplitude detector 25 and first phase detector 26 may be configured with one detector performing amplitude detection and phase detection to output supplied power amplitude information TM and supplied power phase information TP.

Supplied power amplitude information TM and supplied power phase information TP may not be two separate signals. Supplied power amplitude information TM and supplied power phase information TP may be included in one signal. The same applies to second amplitude detector 27 and second phase detector 28.

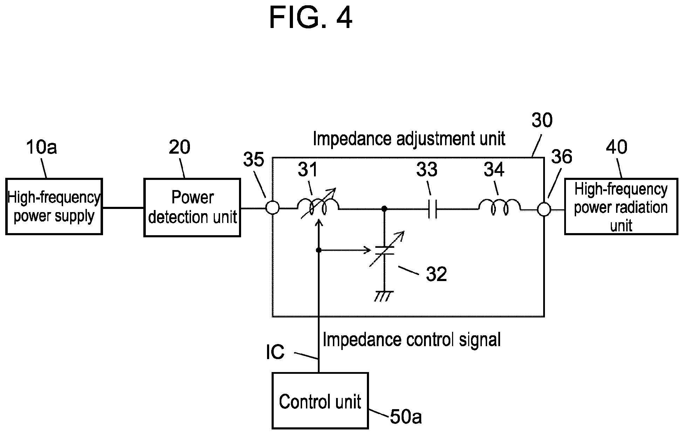

FIG. 4 is a diagram illustrating a circuit configuration of impedance adjustment unit 30. FIG. 4 also illustrates other components (high-frequency power supply 10a, power detection unit 20, high-frequency power radiation unit 40, and control unit 50a) connected to impedance adjustment unit 30.

As illustrated in FIG. 4, impedance adjustment unit 30 includes variable inductance 31, variable capacitance 32, fixed capacitance 33, and fixed inductance 34. Impedance adjustment unit 30 outputs the high-frequency power output from power detection unit 20 to high-frequency power radiation unit 40.

Input end 35 of impedance adjustment unit 30 is connected to power detection unit 20, and output end 36 of impedance adjustment unit 30 is connected to high-frequency power radiation unit 40. Variable inductance 31 is connected to input end 35 of impedance adjustment unit 30, and fixed inductance 34 is connected to output end 36 of impedance adjustment unit 30.

Fixed capacitance 33 is connected between variable inductance 31 and fixed inductance 34. One end of variable capacitance 32 is connected between variable inductance 31 and fixed capacitance 33. The other end of variable capacitance 32 is grounded.

Control unit 50a outputs impedance control signal IC to change an inductance value of variable inductance 31 and a capacitance value of variable capacitance 32.

To change the inductance value of variable inductance 31, for example, a coil length of variable inductance 31 may be mechanically expanded or contracted. Alternatively, the inductance value of variable inductance 31 may be changed by changing a length of core material inserted to change magnetic permeability. Alternatively, a synthesized inductance value of a plurality of fixed inductances may be changed by switching connection of the plurality of fixed inductances arranged in a series or parallel.

To change the capacitance value of variable capacitance 32, for example, a variable capacitor that can change electrostatic capacitance may be used. Alternatively, a variable capacitance diode that can change the capacitance value by a reverse bias voltage of the diode may be used. Alternatively, a synthesized capacitance value of a plurality of fixed capacitances may be changed by switching connection of the plurality of fixed capacitances arranged in a series or parallel.

Impedance adjustment unit 30 changes both or one of the inductance value of variable inductance 31 and the capacitance value of variable capacitance 32 according to impedance control signal IC. This enables impedance adjustment unit 30 to adjust the load impedance relative to power amplifier 12 of high-frequency power supply 10a in FIG. 2 to a target impedance.

FIG. 4 gives an example of the circuit configuration of impedance adjustment unit 30. The number of variable inductances, variable capacitances, fixed inductances, and fixed capacitances included in impedance adjustment unit 30 and their arrangements and connection sequences are not limited to the present exemplary embodiment.

As described above, in high-frequency processing device 1a according to the present exemplary embodiment, the high-frequency power generated by high-frequency power supply 10a is emitted toward target object 60 from high-frequency power radiation unit 40 via power detection unit 20 and impedance adjustment unit 30. In this way, processing is performed on target object 60.

Power detection unit 20 detects the magnitude and phase of the supplied power and the magnitude and phase of the reflected power, and outputs detected information to control unit 50a. Control unit 50a outputs impedance control signal IC to impedance adjustment unit 30. Impedance adjustment unit 30 changes the load impedance relative to high-frequency power supply 10a according to impedance control signal IC.

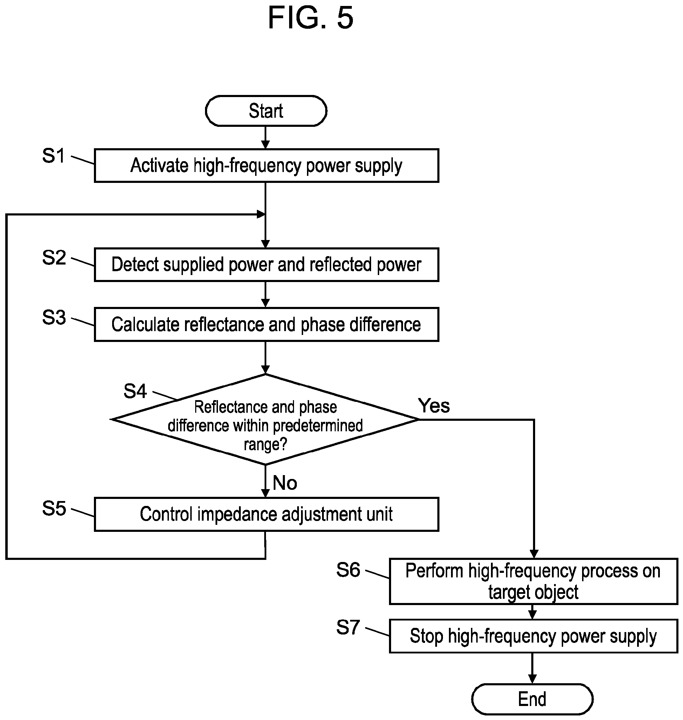

Next, the operation of high-frequency processing device 1a will be described. FIG. 5 is a flow chart illustrating a basic control procedure of high-frequency processing device 1a. Control unit 50a performs the following process in high-frequency processing device 1a.

As illustrated in FIG. 5, to start a heating process, control unit 50a activates high-frequency power supply 10a to start the high-frequency power output (Step S 1). Control unit 50a obtains supplied power information T and reflected power information R from power detection unit 20 (Step S2). Control unit 50a calculates the reflectance and the phase difference (Step S3). Control unit 50a can calculate the reflectance by a ratio of reflected power amplitude information RM to supplied power amplitude information.

Control unit 50a determines whether or not the reflectance and the phase difference calculated are the predetermined reflectance and the predetermined phase difference, respectively (Step S4). This determination is made by determining whether or not the reflectance calculated falls within a predetermined range of the reflectance and by determining whether or not the phase difference calculated falls within a predetermined range of the phase difference.

The predetermined range of the reflectance and the predetermined range of the phase difference define a predetermined region of the reflectance and the phase difference. This predetermined region is defined corresponding to the output power of high-frequency power supply 10a. The predetermined region will be detailed later.

When the reflectance and phase difference calculated are within the predetermined region, control unit 50a performs the high-frequency process on target object (Step S6). When control unit 50a stops the high-frequency power output from high-frequency power supply 10a after completing the high-frequency process (Step S7), high-frequency processing device 1a ends the high-frequency process.

When one of the reflectance and phase difference calculated is not within the predetermined region, control unit 50a causes impedance adjustment unit 30 to adjust the impedance at input end 35 (Step S5). In this way, control unit 50a makes the reflectance and the phase difference fall within the predetermined region of the reflectance and the phase difference.

Then, control unit 50a proceeds the process to Step S2 to repeat the process from Step S2 to Step S5. How the reflectance and the phase difference are guided to and maintained within the predetermined region will be detailed later.

In the flow chart illustrated in FIG. 5, the high-frequency process is performed on target object 60 in Step S6. However, strictly speaking, emission of the high-frequency power from high-frequency power radiation unit 40 starts at the time the high-frequency power supply is activated in Step S1. Still more, the high-frequency process is performed on target object 60 using the high-frequency power from which the reflected power and power consumed inside impedance adjustment unit 30 are subtracted.

Therefore, it may be considered that the high-frequency process is performed on target object 60 for a duration of processing time in Step S6 and processing time from a start point of activating the high-frequency power supply to a time point when both the reflectance and the phase difference are determined to become the predetermined values in Step S4.

Now, the predetermined region of the reflectance and the phase difference and the control to guide the reflectance and the phase difference to and maintain the reflectance and the phase difference within the predetermined region will be described.

When power amplifier 12 of high-frequency power supply 10a includes an amplifying element such as a high-output high-frequency transistor, an impedance value of each of an input terminal and an output terminal of the amplifying element is an extremely low value of about several ohms or less. For example, the input terminal of the amplifying element is a gate terminal of the transistor, and the output terminal of the amplifying element is a drain terminal of the transistor.

Therefore, an input matching circuit (not illustrated) is connected to the input terminal of the amplifying element, and an output matching circuit (not illustrated) is connected to the output terminal of the amplifying element. With this connection, an impedance of the input terminal of the amplifying element is matched with an impedance of the circuit connected to the input terminal of the amplifying element, and an impedance of the output terminal of the amplifying element is matched with an impedance of the circuit connected to the output terminal of the amplifying element.

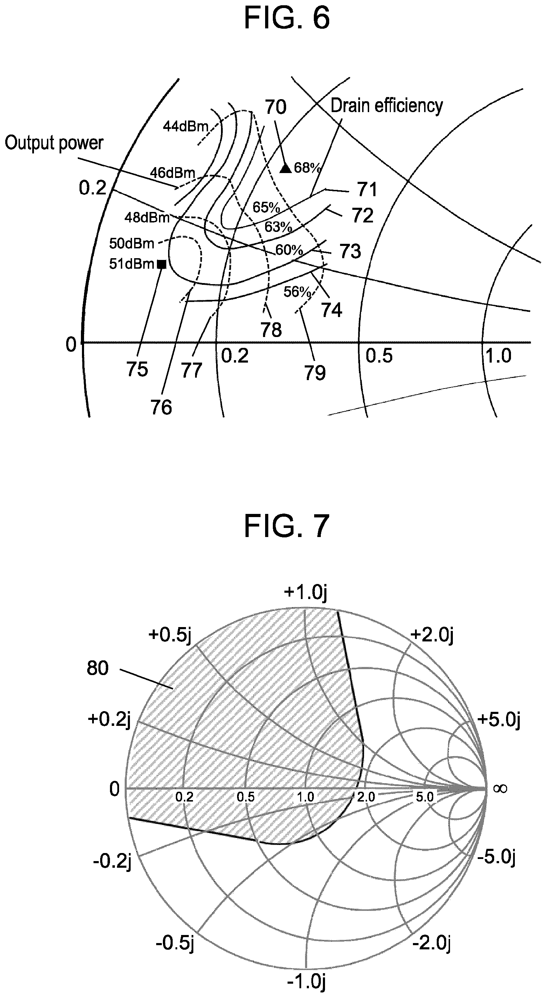

FIG. 6 is an example of output load characteristics of the high-output high-frequency transistor. In FIG. 6, a drain efficiency relative to an output load state of the transistor and the maximum output power are mapped in a contour-line pattern on a Smith chart.

As illustrated in FIG. 6, the operation of the high-output high-frequency transistor drastically changes depending on a load impedance state. From the perspective of the drain efficiency, the highest drain efficiency is achieved in the impedance state at point 70. The drain efficiency at this point is 68%.

As the impedance state departs from point 70, a value of the drain efficiency reduces to 65% indicated by contour line 71, 63% indicated by contour line 72, 60% indicated by contour line 73, and 56% indicated by contour line 74 in this order.

From the perspective of the maximum output power, the maximum output power is achieved in the impedance state at point 75. The maximum output power at this point is 51 dBm. As the impedance state departs from point 75, a value of the maximum output power reduces to 50 dBm indicated by contour line 76, 48 dBm indicated by contour line 77, 46 dBm indicated by contour line 78, and 44 dBm indicated by contour line 79 in this order.

As illustrated in FIG. 6, the drain efficiency and the output power have a trade-off relationship. Therefore, it is necessary to consider the balance between required output power and required drain efficiency at designing the input matching circuit and the output matching circuit, so as to achieve an appropriate load impedance state. In particular, the drain efficiency greatly affects power consumption in the transistor. Thus, it is necessary to pay attention not to perform the high-output operation in a state of low drain efficiency.

FIG. 7 is a Smith chart indicating an impedance region of a load normalized by an output impedance (50 S2 in the present disclosure) of high-frequency power supply 10a. In FIG. 7, predetermined impedance region 80 (shaded part) is a preferable range of load impedance values corresponding to the output power of high-frequency power supply 10a.

In other words, when the load impedance value during the high-frequency process is maintained within predetermined impedance region 80, the high-frequency transistor of power amplifier 12 can operate without being damaged with the required output power appropriate for performing the high-frequency process on target object 60. Predetermined impedance region 80 is specified based on the output load characteristics of the high-frequency transistor illustrated in FIG. 6.

The Smith chart is a circular chart indicating complex impedances used in designing impedance matching. A center of the Smith chart indicates a load impedance value that does not generate reflected power.

In the present disclosure, since the output impedance of high-frequency power supply 10a is 50 Ω, the load impedance value at the center of the Smith chart is 50 S2. The reflectance increases at positions further away from the center. A circumference indicates the load impedance value in the state of total reflection.

The Smith chart expresses the load impedance value by a distance between the center and an arbitrary point on the chart, and an angle formed by a straight line extending leftward from the center and a line segment from the center to the arbitrary point. The above-described distance corresponds to the magnitude of reflectance, and the above-described angle corresponds to a relative phase of the reflected power to the supplied power.

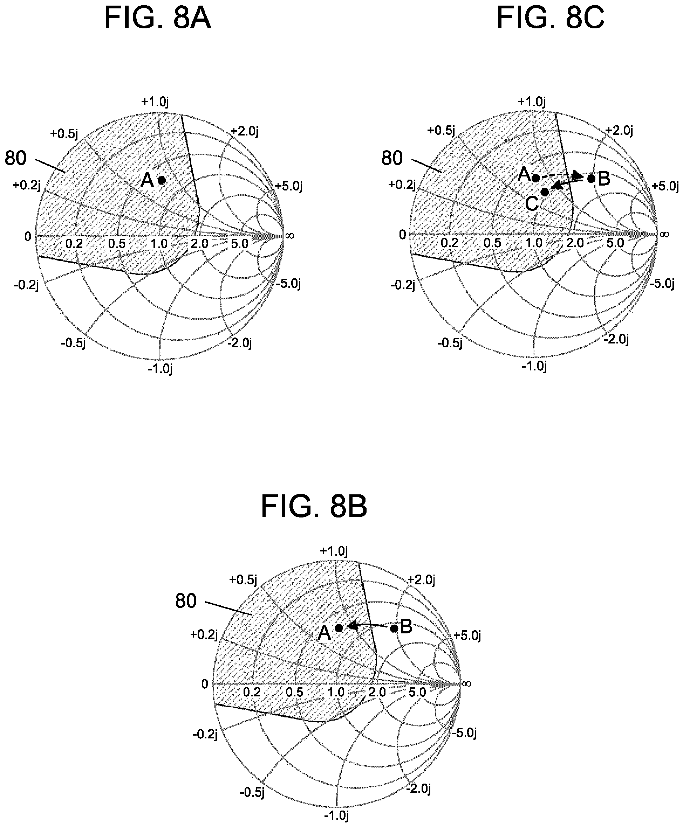

An example of how impedance adjustment unit 30 controls the load impedance relative to high-frequency power supply 10a will be described with reference to FIGS. 8A to 8C. FIGS. 8A to 8C are Smith charts illustrating the impedance control by impedance adjustment unit 30 relative to the output from high-frequency power supply 10a.

As described above, control unit 50a obtains supplied power information T and reflected power information R from power detection unit 20 (Step S2 in FIG. 5). Control unit 50a calculates the reflectance and the phase difference from supplied power information T and reflected power information R (Step S3 in FIG. 5). The reflectance and the phase difference are values depending on the load impedance.

When the load impedance value calculated is indicated by point A in FIG. 8A, the load impedance value falls within predetermined impedance region 80 corresponding to the output power at that time. In this case, impedance adjustment unit 30 does not need to adjust the load impedance value.

As described above, control unit 50a obtains the load impedance value from the reflectance and the phase difference. Therefore, control unit 50a determines a position of the load impedance value on the Smith chart illustrated in FIG. 7 and the like based on the reflectance and the phase difference.

When the impedance value calculated is indicated by point B in FIG. 8B, the load impedance value is out of predetermined impedance region 80 corresponding to the output power at that time. In this case, control unit 50a controls impedance adjustment unit 30 to move the load impedance value to within impedance region 80 (point A in FIG. 8B).

While the high-frequency process is performed on target object 60, control unit 50a performs a process in Steps S2 to S4 in FIG. 5 at predetermined time intervals or continuously to determine whether the load impedance value falls within predetermined impedance region 80.

When the load impedance value falls within predetermined impedance region 80 corresponding to the output power at that time, control unit 50a causes impedance adjustment unit 30 to adjust the load impedance value, so as to maintain the load impedance value within predetermined impedance region 80.

For example, when the load impedance value falls within predetermined impedance region 80 (point A in FIG. 8C) corresponding to the output power at that time, the load impedance value may move out of predetermined impedance region 80 (point B in FIG. 8C) due to a change of impedance of target object 60 by the high-frequency process performed on target object 60.

In this case, control unit 50a controls impedance adjustment unit 30 to move the load impedance value to within predetermined impedance region 80 (point C in FIG. 8C). In other words, the reflectance and the phase difference can be adjusted to the predetermined reflectance corresponding to the output power and the predetermined phase difference corresponding to the output power, respectively.

As a result, high-frequency processing device 1a can perform the high-frequency process on target object 60 in a state that the load impedance value is maintained within predetermined impedance region 80 corresponding to the output power at that time.

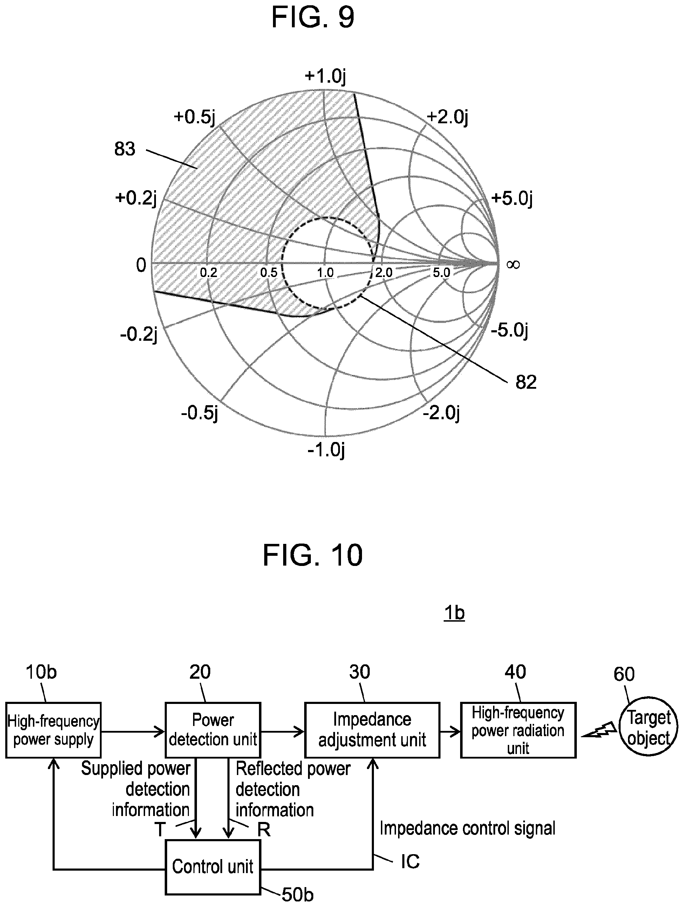

FIG. 9 is a diagram illustrating a region to be avoided in the predetermined impedance region corresponding to the output power of high-frequency power supply 10a. Control unit 50a sets a shaded region in FIG. 9 as predetermined impedance region 83 so as to avoid the reflectance from entering region 82 indicated by a dotted line in FIG. 9. Region 82 is a region in which the reflectance is less than or equal to a predetermined threshold. In other words, control unit 50a controls impedance adjustment unit 30 to maintain the load impedance value within the predetermined impedance region corresponding to the output power at that time without excessively decreasing the reflectance.

Accordingly, a detection accuracy of first phase detector 26 and second phase detector 28 in power detection unit 20 can be improved. As a result, the reflectance and the phase difference can be further accurately calculated.

### (Second exemplary embodiment)

A second exemplary embodiment of the present disclosure will be described below mainly on a difference with the first exemplary embodiment. Components same or practically equivalent to those in the first exemplary embodiment may be given same reference marks to omit their description.

FIG. 10 is a block diagram illustrating a basic configuration of high-frequency processing device 1b according to the second exemplary embodiment of the present disclosure.

As illustrated in FIG. 10, high-frequency processing device 1b includes high-frequency power supply 10b instead of high-frequency power supply 10a, and control unit 50b instead of control unit 50a. Power detection unit 20, impedance adjustment unit 30, and high-frequency power radiation unit 40 have configurations same as those in the first exemplary embodiment.

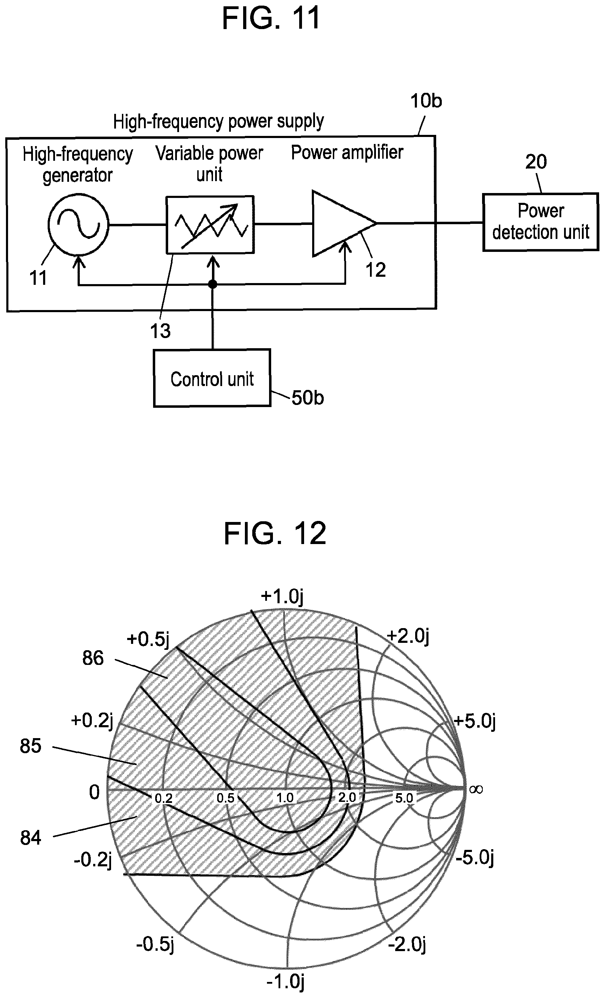

FIG. 11 is a block diagram illustrating a configuration of high-frequency power supply 10b. In FIG. 11, other components (power detection unit 20 and control unit 50b) connected to high-frequency power supply 10b are also illustrated. As illustrated in FIG. 11, high-frequency power supply 10b includes high-frequency generator 11, variable power unit 13, and power amplifier 12. High-frequency generator 11 and power amplifier 12 have the same configurations as those in the first exemplary embodiment.

Variable power unit 13 is a variable attenuator that attenuates a high-frequency signal from high-frequency generator 11 according to a control signal from control unit 50b. Variable power unit 13 has a well-known configuration. Variable power unit 13 may be, for example, a multi-bit-step variable attenuator such as a field effect transistor (FET) switch circuit network or a continuously variable attenuator such as a PIN diode network.

In the present exemplary embodiment, variable power unit 13 is the variable attenuator. However, variable power unit 13 may also be a variable gain amplifier. In FIG. 11, variable power unit 13 and power amplifier 12 are configured separately. However, variable power unit 13 and power amplifier 12 may be configured with one variable-gain power amplifying circuit.

With this configuration, high-frequency processing device 1b emits high-frequency power of arbitrary magnitude according to a purpose of processing on target object 60, so as to perform a high-frequency process on target object 60.

Same as the first exemplary embodiment, power detection unit 20 detects supplied power and reflected power, and outputs supplied power information T and reflected power information R to control unit 50b. Control unit 50b outputs impedance control signal IC to impedance adjustment unit 30. Impedance adjustment unit 30 changes a load impedance relative to high-frequency power supply 10b according to impedance control signal IC.

In the present exemplary embodiment, the reflected power is defined as the high-frequency power, in the supplied power, reflected on target object 60 and flowing reversely to high-frequency power supply 10a via high-frequency power radiation unit 40. However, as long as the high-frequency power flows reversely to high-frequency power supply 10b, high-frequency power flowing reversely due to other reasons may be defined as the reflected power.

For example, power detection unit 20 may detect reversely-flowing high-frequency power that is not emitted from high-frequency power radiation unit 40 but reflected on high-frequency power radiation unit 40 as the reflected power. Still more, power detection unit 20 may detect reversely-flowing high-frequency power that is not entering impedance adjustment unit 30 but reflected on impedance adjustment unit 30 as the reflected power. Furthermore, power detection unit 20 may separate and detect only the reflected power from any of reflective surfaces, or may detect entire reflected power from all reflective surfaces as the reflected power.

The operation of the above-described high-frequency processing device 1b will be described mainly on a difference with high-frequency processing device 1a in the first exemplary embodiment.

In high-frequency processing device 1b, same as high-frequency processing device 1a, control unit 50b calculates a reflectance and a phase difference, i.e., a load impedance value relative to high-frequency power supply 10b, from supplied power information T and reflected power information R.

Control unit 50b causes impedance adjustment unit 30 to move, based on the results, the load impedance value to within a predetermined impedance region corresponding to magnitude of supplied power.

FIG. 12 is a diagram illustrating three predetermined impedance regions 84, 85, and 86 in an output of high-frequency power supply 10b. These predetermined impedance regions are specified corresponding to the magnitude of supplied power.

In other words, predetermined impedance region 84 corresponds to a case where the output power is low (e.g., 200 W). Predetermined impedance region 85 corresponds to a case where the output power is medium (e.g., 500 W). Predetermined impedance region 86 corresponds to a case where the output power is high (e.g., 800 W). When the load impedance is maintained within the predetermined impedance region corresponding to the output power at that time, a high-frequency transistor of power amplifier 12 can operate without being damaged.

As illustrated in FIG. 12, predetermined impedance region 84 includes predetermined impedance region 85 and predetermined impedance region 86. Predetermined impedance region 85 includes predetermined impedance region 86.

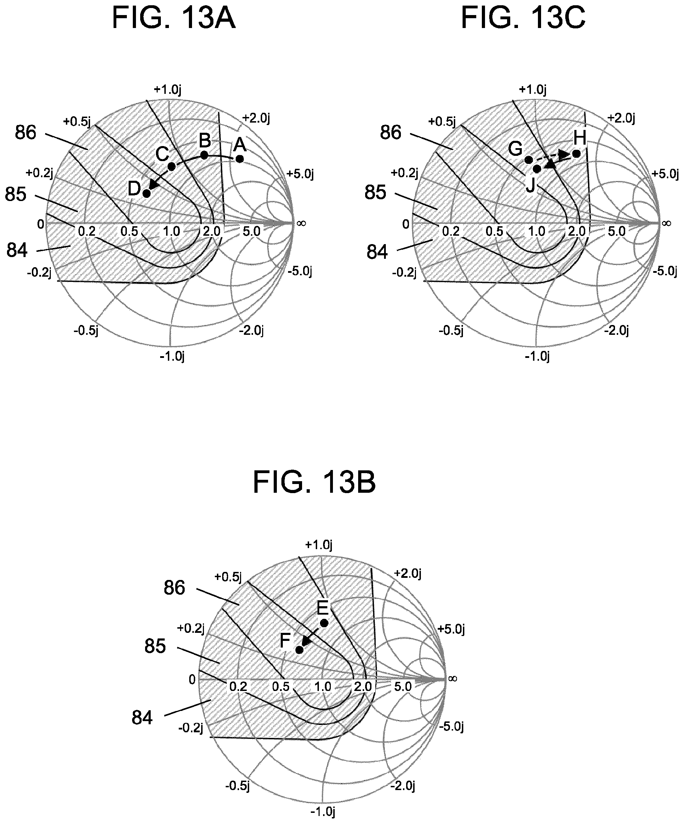

How control unit 50b causes impedance adjustment unit 30 to adjust the load impedance relative to high-frequency power supply 10b will be described with reference to FIGS. 13A to 13C. FIGS. 13A to 13C are diagrams illustrating impedance control with respect to the output of the high-frequency power supply by impedance adjustment unit 30.

Same as the first exemplary embodiment, control unit 50b obtains supplied power information T and reflected power information R from power detection unit 20. Control unit 50b calculates the reflectance and the phase difference. These values correspond to the load impedance value.

When the impedance value calculated is indicated by point A in FIG. 13A, the load impedance value is out of predetermined impedance region 84. In this case, control unit 50b needs to cause impedance adjustment unit 30 to adjust the load impedance in order to move the load impedance value in FIG. 13A.

The load impedance value is moved to the predetermined region corresponding to the magnitude of supplied power. In other words, when the magnitude of supplied power is low (e.g., output of 200 W), the load impedance value is moved from point A in FIG. 13A to any one of points B, C, and D in FIG. 13A. In FIG. 13A, points B, C, and D are located in predetermined impedance region 84, predetermined impedance region 85, and predetermined impedance region 86, respectively.

When the magnitude of supplied power is medium (e.g., output of 500 W), the load impedance value is moved from point A in FIG. 13A to point C or point D in FIG. 13A. When the magnitude of supplied power is high (e.g., output of 800 W), the load impedance value is moved from point A in FIG. 13A to point D in FIG. 13A.

In another example, when the impedance value similarly calculated is indicated by point E in FIG. 13B, the load impedance value is within predetermined impedance region 85. Therefore, when the magnitude of supplied power is up to medium, control unit 50b does not need to cause impedance adjustment unit 30 to adjust the load impedance value.

When the magnitude of high-frequency power emitted from high-frequency power radiation unit 40 to target object 60 is high (e.g., 800 W), control unit 50b controls impedance adjustment unit 30 to move the load impedance value calculated to predetermined impedance region 86 (point F in FIG. 13B).

In still another example, when the load impedance value similarly calculated is indicated by point G in FIG. 13C, the load impedance value is within predetermined impedance region 85. In this case, an impedance state of target object 60 changes while the high-frequency process is performed on target object 60. As a result, the load impedance value moves to predetermined impedance region 84 (point H in FIG. 13C).

In this case, control unit 50b controls impedance adjustment unit 30 to move the load impedance to within predetermined impedance region 85 (point J in FIG. 13C).

Same as the first exemplary embodiment, control unit 50b performs the process from Steps S2 to S4 in FIG. 5 at predetermined time intervals or continuously while the high-frequency process is performed on target object 60, so as to determine a relationship between the load impedance value and predetermined impedance regions 84, 85, and 86 corresponding to the magnitude of supplied power.

When the load impedance value falls in any of predetermined impedance regions 84, 85, and 86, control unit 50a controls impedance adjustment unit 30 to maintain the load impedance value within the predetermined impedance region corresponding to the magnitude of supplied power.

According to the present exemplary embodiment, the reflectance and the phase difference can be adjusted to the predetermined reflectance corresponding to the output power and the predetermined phase difference corresponding to the output power, respectively.

As illustrated in FIG. 12, when a permissible high-frequency power value differs by load impedance value, power may be increased within a permissible range during impedance adjustment in order to reduce time from starting to ending the high-frequency process.

For example, when target object 60 is subject to the high-frequency process at 800 W in Step S6, control unit 50b sets the high-frequency output to the maximum power value (e.g., 200 W) permissible in predetermined impedance region 84 when the load impedance value enters predetermined impedance region 84 while the load impedance value indicated in FIG. 13A moves from point A to point D.

Still more, when the load impedance value enters predetermined impedance region 85, control unit 50b sets the high-frequency output to the maximum power value (e.g., 500 W) permissible in predetermined impedance region 85. When the load impedance value enters predetermined impedance region 86, control unit 50b may set the high-frequency output to 800 W and proceed to Step S6 in FIG. 5 to perform the high-frequency process on target object 60.

As illustrated in FIG. 7, when the predetermined impedance region is broad and a state from no reflection to total reflection or close to total reflection is permissible, control unit 50b may control only the phase. To improve the efficiency of the high-frequency process, control unit 50b may control the phase to a predetermined value while reducing the reflected power to less than or equal to a predetermined value.

### INDUSTRIAL APPLICABILITY

The present disclosure offers the high-frequency processing device operable to prevent a damage to the high-frequency amplifying device of the high-frequency power supply and maintaining a high processing capability without decreasing the high-frequency power output. Therefore, the present disclosure is effectively applicable to apparatuses using electromagnetic waves such as microwave ovens and driers.

### REFERENCE MARKS IN THE DRAWINGS

1a, 1b high-frequency processing device
10a, 10b high-frequency power supply
11 high-frequency generator
12 power amplifier
13 variable power unit
20 power detection unit
21 supplied power detector
22 reflected power detector
23 supplied power detection unit
24 reflected power detection unit
25 first amplitude detector
26 first phase detector
27 second amplitude detector
28 second phase detector
30 impedance adjustment unit
31 variable inductance
32 variable capacitance
33 fixed capacitance
34 fixed inductance
35 input end
36 output end
40 high-frequency power radiation unit
50a, 50b control unit
60 target object
70, 75 point
71, 72, 73, 74, 75, 76, 77, 78, 79 contour line
80, 83, 84, 85, 86 predetermined impedance region
82 region

## Claims

1. A high-frequency processing device configured to perform a high-frequency process on a target object, the high-frequency processing device comprising:
a high-frequency power supply configured to generate high-frequency power of variable magnitude;
a high-frequency power radiation unit configured to emit the high-frequency power toward the target object;
an impedance adjustment unit configured to adjust a load impedance relative to the high-frequency power supply;
a power detection unit configured to detect supplied power from the high-frequency power supply and reflected power flowing reversely to the high-frequency power supply; and
a control unit configured to control the high-frequency power supply and the impedance adjustment unit, wherein
the control unit is operable to calculate a reflectance that is a ratio of the reflected power to the supplied power, and a phase difference between the supplied power and the reflected power, and
the control unit is operable to adjust the reflectance and the phase difference to a predetermined reflectance and a predetermined phase difference, respectively, by causing the impedance adjustment unit to adjust the load impedance.

2. The high-frequency processing device according to claim 1, wherein
the control unit is operable to make determination on whether or not the reflectance and the phase difference fall within a predetermined region corresponding to output power of the high-frequency power supply, and
the control unit is operable to guide the reflectance and the phase difference to within the predetermined region and maintaining the reflectance and the phase difference within the predetermined region by causing the impedance adjustment unit to adjust the load impedance.

3. The high-frequency processing device according to claim 1 or 2, wherein
the control unit is operable to make the determination on whether or not the reflectance and the phase difference fall within the predetermined region by obtaining the load impedance from the reflectance and the phase difference and determining whether or not the load impedance is at a position within a predetermined impedance region corresponding to output power of the high-frequency power supply, and
the control unit is operable to guide the reflectance and the phase difference to within the predetermined region and maintaining the reflectance and the phase difference within the predetermined region by causing the impedance adjustment unit to guide the load impedance to and maintain the load impedance within the predetermined impedance region.

4. The high-frequency processing device according to any one of claims 1 to 3, wherein
the power detection unit is configured to detect the supplied power and the reflected power at predetermined time intervals or continuously while the high-frequency process is performed on the target object, and the control unit is operable to calculate the reflectance and the phase difference.

5. The high-frequency processing device according to any one of claims 1 to 4, wherein
the control unit is operable to cause the impedance adjustment unit to adjust the load impedance to prevent the reflectance from becoming less than or equal to a predetermined threshold.
